# EUROPEAN PATENT SPECIFICATION

(11) **EP 0 262 580 B1**
(45) Date of publication and mention of the grant of the patent: **24.11.1993**
(21) Application number: 87113934.1
(22) Date of filing: 23.09.1987
(51) Int. Cl.: H01L 21/60, H01L 21/603

(54) **Method of electrically bonding two objects**
Verfahren zum elektrischen Verbinden von zwei Objekten
Procédé pour lier électriquement deux objets

(30) Priority: 25.09.1986 JP 224765/86; 27.03.1987 JP 71651/87; 12.05.1987 JP 113698/87
(43) Date of publication of application: 06.04.1988
(73) Proprietor: KABUSHIKI KAISHA TOSHIBA, Kawasaki-shi, Kanagawa-ken 210 (JP)
(72) Inventor: Morita, Hiroshi c/o Patent Division, Minato-ku Tokyo 105 (JP); Ishizawa, Keiko c/o Patent Division, Minato-ku Tokyo 105 (JP); Yoshino, Thunekazu c/o Patent Division, Minato-ku Tokyo 105 (JP); Naito, Hisashi c/o Patent Division, Minato-ku Tokyo 105 (JP); Nakagawa, Masashi c/o Patent Division, Minato-ku Tokyo 105 (JP)
(74) Representative: Henkel, Feiler, Hänzel & Partner

(56) References cited:
- EP-A- 0 068 091
- EP-A- 0 147 576
- EP-A- 0 186 829
- US-A- 3 839 727
- US-A- 4 237 607
- ECC 21ST ELECTRONIC COMPONENTS CONFERENCE, Washington, D.C., 10th-12th May 1971, pages 275-284; P.A. TOTTA: "Flip chip solder terminals"
- IEEE 20TH ANNUAL PROCEEDINGS RELIABILITY PHYSICS, San Diego, California, 30th-31st March 1982, pages 194-201, IEEE; R.A. YOUNG et al.: "Analytical techniques for controlled collapse bump structures"

## Description

The present invention relates to a method of electrically bonding electrode terminals of an electronic component such as a semiconductor device to the connection terminals of a to-be-bonded object, such as the conductive patterns on a printed circuit board.

Recently, technical improvement of semiconductor integrated circuits increases its density and integrated circuits with more than 100 terminals are appearing. There is now a demand for technical development of effectively bonding a high-density integrated circuit device to a printed circuit board. Much attention is directed to the flip chip method that bonds a number of electrode terminals of a semiconductor integrated circuit device to the printed circuit board in one bonding process.

The "flip chip method" is a general term for the face-down bonding which connects a semiconductor device with its active face down to bonding pattern terminals formed on a board. This method is classified into two: the technique to effect the bonding after a bump is formed on the semiconductor device on the electrode terminal side and the technique to effect bonding after a bump is formed on a solid device or a printed circuit board on the connection terminal side.

To form the bump by the former technique, it is well known to form a Cr/Cu/Au or Ti/Ni/Au lamination by the vapor deposition and then to plate a Pb-Sn solder. According to the latter technique, it is known to print or plate a Pb-Sn solder. With the use of either technique, the bump formation requires a complex process which results in a high rate of defects.

The flip-chip method bonds the electrode terminals of a semiconductor device to the connection terminals of a solid device or a printed circuit board under a high temperature of 250 to 330°C. However, when solder used for the connection terminals is cooled down to the ambient temperature from the high temperature used for the solder melting and bonding, separation or cracking would occur due to a temperature deformation that originates in the difference between the thermal expansion coefficients of the semiconductor device and the circuit board, thus impairing the device's reliability. Further, since the durable temperature of the color filter of a color liquid display device (e.g., a-SiTFT type) is about 150°C, the characteristic of the color filter at this temperature is impaired.

There is another method, the film carrier method, for bonding the electrode terminals of the semiconductor device to the connection terminals of the circuit board. This method bonds the wires on a resin film to the electrode terminals on the semiconductor device by thermocompression. That is, a bump consisting of Ti/Ni/Pd/Au is formed on an Aℓ electrode terminal of the semiconductor device and Sn is adhered to the Cu wires of a film carrier. Both of these are put under a high pressure of 1.96·10⁷ Pa to 9.81·10⁷ Pa [200 to 1000 kg/cm²] (20 to 100 g per terminal of 100 µm × 100 µm) at a temperature of 450 to 500°C and are bonded by Au-Sn eutectic. However, the film carrier method causes a temperature deformation by a high temperature as per the flip chip method and may damage a semiconductor device due to a heavy pressure applied thereto.

Further, due to an increase in the number of electrode terminals, it is difficult to uniformly set the height of the electrode terminals. Therefore, a high pressure would be locally generated between the bump and connection terminals (or electrode terminals).

US-A-4 237 607 discloses a method of assembling a semi-conductor integrated circuit in which a semiconductor integrated circuit chip with bumps is bonded to a flexible film circuit substrate. The assembling method of the invention comprises a step of making the highest layer of the bump of solder or a low melting point metal treating the surface of the flexible film circuit substrate by gold-plating, and bonding the semiconductor integrated circuit chip and the flexible film circuit substrate with the former mounted face-down on the latter.

US-A-3 389 727 discloses a solder bond between a semiconductor chip and a substrate which is improved by the addition of a region of solder which is dispersion hardened with a ternary intermetallic. In this prior art the solder is constituted by a solid solution of tin in lead and a uniformly dispersed copper/tin/palladium ternary intermetallic. One of the constituents of the ternary intermetallic is a constituent of a solder.

P. A. Totta, "Flip chip solder terminals", 21^{st} Electronic Components Conference (ECC), Washington, D.C., 10.-12. May 1971, pages 275-284 discloses high lead, soft solder interconnections which were used as the mechanical-electrical joints between glass passivated, silicon flip chips and thick film, alumina substrates. Further this prior art describes the copper ball solder bump, and its monolithic successor, the controlled collapse terminal.

EP-A-0 068 091 discloses to mount a semiconductor chip flip-chip to conductors on a substrate by depositing layers of chromium, copper, and gold on the chip or the substrate. Solder mounds are formed on said layers, and the mounds are reflowed before or during the flip-chip mounting. In this prior art, the copper layer is about 0.08-0.25 µm and the gold layer no more than 0.25 µm thick. Limiting the thickness of these layers reduces mechanical stress in the connection and these avoids cracking of the parts.

EP-A-186 829 discloses a method for the metallic bonding of component which are formed of semiconductor structural elements having a metal plating on a least one side thereof. According to this prior art, a multi-layer bonding material metallic is placed between the component parts. The bonding material includes a core layer of lead or an alloy of tin, antimony and silver. This core layer has a thickness of from about 20 to 60 µm and has both sides thereof plated with a surface layer of e.g. tin. The tow surface layers have a thickness of between 0.2 and 2 µm. Soldering of the component parts in accordance with the known method is performed at a temperature of from about 180 to 350°C. In this method, it is possible to promote the soldering by applying a predetermined pressure.

With the above situation in mind, it is an object of this invention to provide a method for securely bonding electronic components under a low pressure and at a low temperature without damaging a semiconductor device, etc.

This object is achieved by a method as set out in the appended claims.

A bump made of a low-melting point bonding metal, e.g., a low-melting point adhesive alloy, is formed by various methods, on at least one of a terminal of an electronic component and a connection terminal of a target object which is to be electrically connected to this electronic component, and then thermocompression bonding the terminal of the electronic component to the connection terminal of the target object by applying a material for improving the bonding strength to the bonding surface, as needed.

Forming the metal bump may be executed by various methods including the one for simply forming a metal leaf on the terminal and then etching it. For instance, there is a method of disposing a low-melting point bonding metal member above the top of the electrode terminal and then stamping out that portion of the metal member which is aligned with the electrode terminal to fixedly transfer the metal member on the terminal, or a method of sequentially disposing thin films of a plurality of elements constituting a low-melting point bonding metal and then alloying at least the surface layer portion to form a low-melting point bonding metal layer.

In the case of the thin film lamination, the thin film for each element may be formed using ordinary thin film forming techniques such as the vapor depositing method, sputtering method, CVD method, solution applying method and plating method. As the starting material for each thin film, various kinds of materials can be used, which include a metal from which the thin film is formed, an oxide or a fluoride that provides the necessary metal through reduction and an inorganic or organic material that provides the metal layer through decomposition.

With the method, a low-melting point bonding metal of a desired composition, for example, a low-melting point adhesive alloy, is formed on the bonding face of at least one of to-be-bonded objects by disposing thin films of a plurality of elements constituting the alloy one upon another and alloying at least the surface layer portion. This ensures that a low-melting point bonding metal layer can be formed without using an adhesive and has a uniform composition and thickness. Further, yielding defects in a patterning process would be reduced by selectively etching the thin films. Since this bonding metal is firmly bonded to a metal as well as glass or other oxide in a half-melting state by thermocompression, a pair of objects can certainly be bonded in one process at a low temperature.

A low-melting point bonding metal used in this invention is a composition comprising In and Sb and two or more of, for example, Pb, Sn, Zn, Cd and Bi. For instance, the composition may be a low-melting point solder alloy of Pb-Sn or Sn-Zn added as needed with one or several elements having a strong affinity with oxygen, such as Zn, Aℓ, Ti, Si, Cr, Be or a rare earth element. Sb improves the bonding strength at the bonding surface.

To reduce the melting point of such a low-melting point bonding metal, addition of In, Bi, Cd, etc. is effective.

The mechanism that the low-melting point adhesive alloy is easily bonded to glass, an oxide as well as metal is explained by the chemical bonding of (alloy)-Zn-O(oxide). Therefore, the adhesive alloy is easily bonded to SnO₂, In₂O₃, ITO (Indium-Tin-Oxide), ATO (Antimony-Tin-Oxide) etc., which is known as a transparent electrode material, so that it is significantly effective to be used in bonding a electrode to a terminal of driving circuit in a liquid crystal device. Particularly, this effect is prominent in an active matrix type liquid crystal device which uses a number of semiconductor devices. It is needless to say that with the use of this low-melting point adhesive alloy, the bonding is easily effected to metal such as Mo, Cr or Ta that is used for lead wires of a liquid crystal display device.

In general, the electrode terminals of a semiconductor device are formed of aluminum, and the surfaces of the terminals are oxidized to form an Aℓ₂O₃ film which impairs the bonding property and the device's reliability. However, the bonding method using the above-described low-melting point adhesive alloy provides a good bonding property even with the presence of the Aℓ₂O₃ film on the electrode terminal, thus maintaining a high reliability. Alternatively, electrode terminals can be formed by lamination of Al and Sn or Al, Au, and Sn.

This invention uses the aforementioned low-melting point adhesive alloy between to-be-bonded objects to bond them together. Further, as needed, a sufficient amount of an element having a strong affinity with oxygen and, additionally, an element to improve the bonding property at the bonding surface can be applied between the alloy and at least one of the objects so as to easily realize the firm bonding of the objects.

Applying such an element having a strong affinity with oxygen or an element to improve the bonding property may be done by forming a thin film containing the necessary element using the plating method, vapor depositing method, sputtering method, chemical vapor phase growing method, solution coating method or the like. The plating method may be either an electric plating or electroless plating, and the solution coating method applies an acid or alcohol solution of the necessary element or its compound and fires the resulting product to form a thin film.

Such a thin film may be on the surface of either the low-melting point adhesive alloy layer and a to-be-bonded object.

According to this invention, a low-melting point bonding metal, for example, a low-melting point adhesive alloy, is applied between the connection terminal of a to-be-bonded object and the electrode terminal of an electronic component and the terminals are then subjected to thermocompression at a low temperature without melting the alloy, thus providing easy bonding.

The method of bonding a pair of objects with the low-melting point bonding metal applied therebetween requires a low pressure so as to effect a secure bonding at a high reliability without damaging an electronic component such as a semiconductor device. However, it has a problem that the bonding surface often suffers a tradeoff between its electric bonding strength (considered as the electric conductivity at the bonding portion or the reciprocal of the contact resistance) and the mechanical bonding strength, so that it is difficult to satisfy a desired bonding strength and a desired contact conductivity at the same time.

This conventional problem is overcome by the present invention which can effect the bonding under a low pressure to prevent a to-be-bonded object, e.g., a semiconductor device, from being damaged, and permits the bonding portion to have satisfactory electric bonding strength (contact conductivity) and mechanical bonding strength at the same time, thus significantly improving the reliability of the bonding portion.

To realize the above in a method of electrically bonding at least a pair of objects with a low-melting point bonding metal layer applied therebetween, the bonding surface of at least one of the object pair needs to be formed by a plurality of elements having different physical properties.

According to this invention, a low-melting point bonding metal is applied between an electrode terminal of an electronic component, for example, and a connection terminal of an object to be electrically bonded to the component, the bonding surface of at least one of the to-be-bonded objects is formed of at least an element with a high contact conductivity and an element with a high mechanical bonding strength, and the bonding metal is melted to easily and firmly bond the objects.

With the use of the above means, the bonding portion between the to-be-bonded object and the bonding metal satisfies both of the desired contact conductivity and mechanical bonding strength at the same time, thus ensuring the bonding with a high reliability. Specifically, a low-melting point adhesive alloy pad with a softening point of 134 °C and a melting point of 160°C, which was attained by adding to, a Sn-Pb alloy, In as metal to reduce the melting point, Zn as an element having a strong affinity with oxygen and Sb as an element to improve the bonding property at the bonding surface, was well cleaned and then pressure-bonded for 60 seconds under a pressure of 9.81 MPa (100 kg/cm²) at 133 to 155°C. From this it is found that the bonding condition differs depending on the to-be-bonded board, which is shown in the following table.

**Table**

| | Bonding Strength | Contact Resistance |
|---|---|---|
| Sn-plated Cu Foil | 2.94 MPa (30 kg/cm²) | 1 × 10⁻⁶ Ω·cm² |
| Aℓ/Glass | 4.9 MPa (50 kg/cm²) | 1 × 10⁻⁵ Ω·cm² |
| ITO/Glass | 9.81 MPa (100 kg/cm²) | 1 × 10⁻³ Ω·cm² |
| Glass | 14.71 MPa (150 kg/cm²) | Infinity |

The bonding strength was measured as the force to break a lead bonded to the adhesive alloy pad by vertically pulling the lead, while the contact resistance was measured by a well-known 4 point probe method.

As should be obvious from the table, if the bonding surface is divided into an Aℓ surface and an ITO surface for bonding, a sufficient electric bonding is attained at the bonding portion of the Aℓ-low-melting point adhesive alloy pad, while a sufficient mechanical bonding is attained at the bonding portion of the ITO low-melting point adhesive alloy pad, considerably improving the reliability at the bonding portion.

This invention can be more fully understood from the following detailed description when taken in conjunction with the accompanying drawings, in which:
Figs. 1A to 1E are diagrams illustrating a bump forming processes involved in Example 1 of this invention;
Fig. 2 is a diagram showing a bonding process involved in Example 1;
Figs. 3A and 3B are diagrams illustrating a thermocompression pressure bonding involved in Example 1;
Fig. 4 is a diagram showing the relationship between the deformation coefficient of a low-melting point adhesive alloy and the bonding strength according to Example 1;
Figs. 5A to 5C are diagrams illustrating a bonding process involved in Example 2 of this invention;
Figs. 6A to 6C are diagrams illustrating a bonding process involved in Example 3 of this invention; and
Figs. 7A to 7C are diagrams illustrating a bonding process involved in Example 4 of this invention.

### Example 1

Preferred embodiments of this invention will now be explained referring to the accompanying drawings.

To begin with, referring to Figs. 1A to 1E, a method of forming a bump constituted by a low-melting point adhesive alloy will be described in detail.

In Fig. 1A, a low-melting point adhesive alloy 1 (hereinafter referred to as adhesive alloy) is aligned with a silicon wafer 2 having semiconductor devices formed thereon. An oxidation film 202 is formed on silicon wafer 2, and electrode terminals 201 are disposed on oxidation film 202. The adhesive alloy used here is a low-melting point adhesive alloy with a softening point of 134°C, a melting point of 160°C and a thickness of 50 µm, which contains In to reduce the melting point.

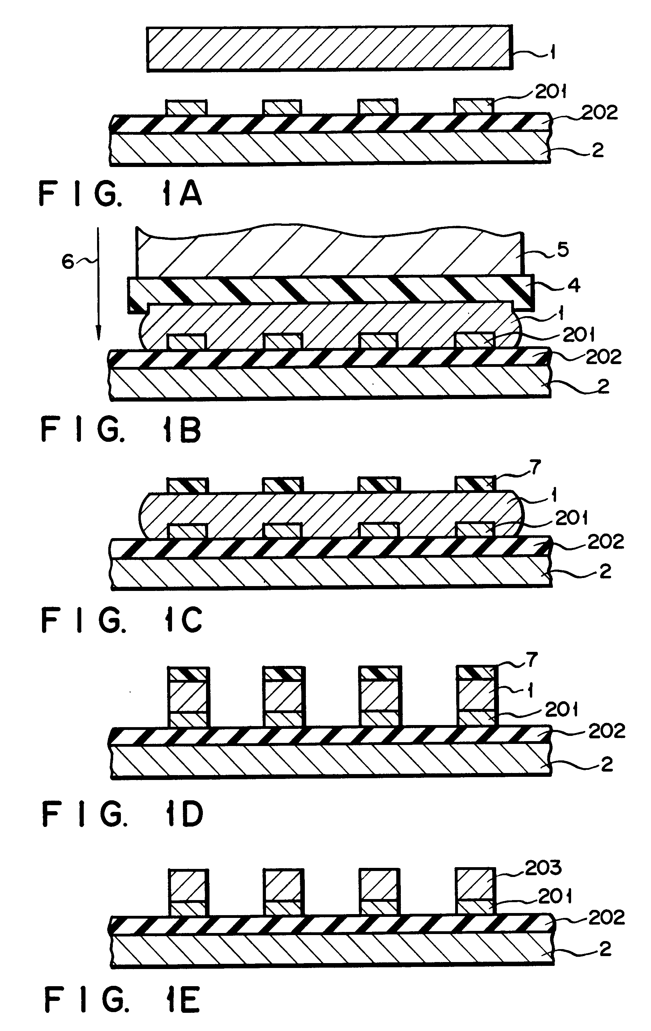

As shown in Fig. 1B, adhesive alloy 1 is disposed on electrode terminals 201 by thermocompression. At this time, a silicon rubber 4 is pressed in the direction of arrow 6 by the distal end 5 of a bellowphragm cylinder. The pressure here is preferably 0.98 MPa to 9.81 MPa (10 to 100 kg/cm²), and silicon wafer 2 is heated up to 140 to 150°C on a heat block (not shown) so as to cause plastic deformation of adhesive alloy 1, which completes the thermocompression.

Then, a resist 7 is applied to the resultant product as shown in Fig. 1C, and is then subjected to exposure and etching, yielding islands of adhesive alloy 1 as shown in Fig. 1D. After this, resist 7 is removed to form bumps 203 consisting of adhesive alloy on electrode terminals 201 as shown in Fig. 1E.

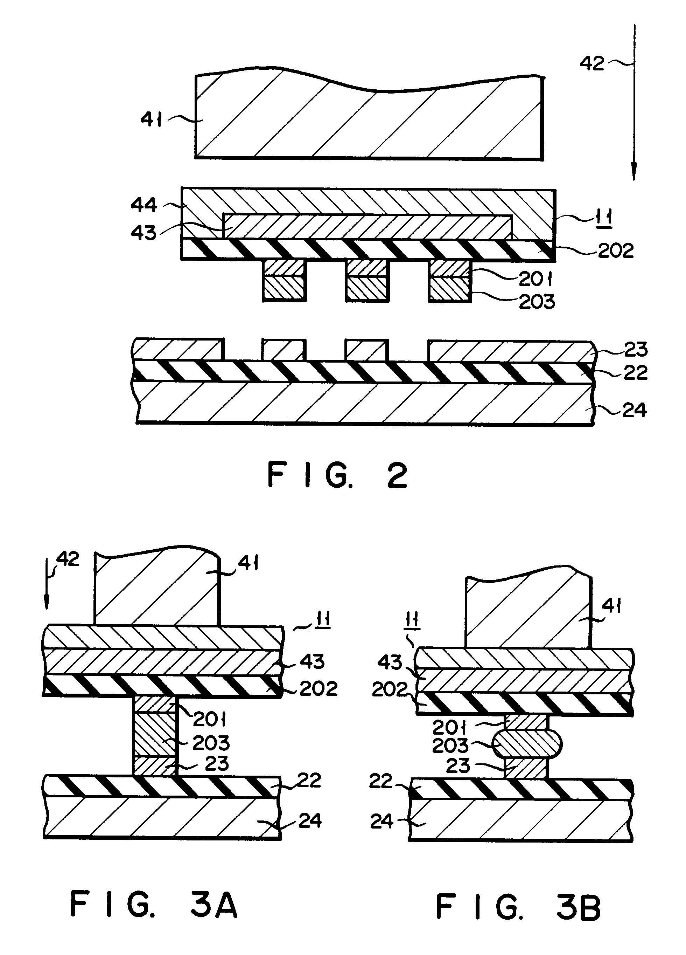

Referring now to Fig. 2, thermocompression of a semiconductor device 11 having bumps 203 formed through the process shown in Figs. 1A to 1E, and a connection terminal 23 formed on a printed circuit board 24 will be described in detail.

In Fig. 2, connection terminals 23 (including a conductive wire in this embodiment) are disposed, through an insulative film 22 as needed, on circuit board 24 in alignment with electrode terminals 201 of semiconductor device 11. Electrode terminals 201 and connection terminals 23 are made of metal.

Then, electrode terminals 201 of semiconductor device 11, on which bumps 203 are formed, and connection terminals 23 of circuit boards 24 are aligned with each other and are then pressed in the arrow direction 42 using a tool 41 to effect thermocompression.

In Fig. 2, reference numeral "43" and "44" respectively denote a functional circuit and a silicon substrate.

In this example, an In additive was used in the adhesive alloy to provide it with a low melting point. More specifically, the low-melting point adhesive alloy comprises Sb of 2 weight %, Pb of 20 weight %, Sn of 66 weight %, In of 10 weight % and Zn of 2 weight %. Since the adhesive alloy has a softening point of 134°C and a melting point of 160°C, the temperature range to permit the thermal pressure bonding lies between these two temperatures. In this example, the thermal pressure bonding was effected at 150°C.

The mechanism for performing the thermocompression in this invention will now be explained.

Fig. 3A illustrates tool 41 pressing connection terminal 23 against electrode terminal 201 of semiconductor device 11 through bump 203 made of active metal.

In Fig. 3A, it is preferable that pressure of tool 41 in arrow direction 42 is 0.98 MPa to 9.81 MPa (10 to 100 kg/cm²). In other words, with the area of each electrode terminal 201 being 100 × 100 µm², the preferable pressure would be 1 to 10 g per terminal. Circuit board 24 having connection terminal 23, which is fixedly disposed on the heat block (not shown), should desirably be applied with a temperature bias of 100 to 120°C.

Turning on the heater disposed inside tool 41 can heat adhesive alloy 203 to 140 to 150°C in several seconds (Here, a pulse heater is used). In this case, it is important that after the temperature of the adhesive alloy reaches the intended level, the heater is turned off but with pressure still applied and the adhesive alloy is cooled down below softening temperature of 134°C with tool 41 then removed. The bonding method of this invention utilized the plastic deformation of the adhesive alloy in a half-melt state and the pressure bonding. Therefore, heating up the adhesive alloy above the melting point would cause defective bonding and result in reduction in yield as a consequence. In this respect it is necessary to provide a sufficient temperature control. With the use of adhesive alloy that has a softening point of 165°C and melting point of 195°C, the preferable pressure is 0.98 MPa to 9.81 MPa (10 to 100 kg/cm²) and the preferable temperature is 170 to 180°C. Paying attention to the adhesive alloy member for the bonding section, the bonding with the highest bonding strength can be realized in one process by heating the low-melting point adhesive alloy at a low temperature without melting it while pressing the metal to deform to be 70 to 95% of the original thickness.

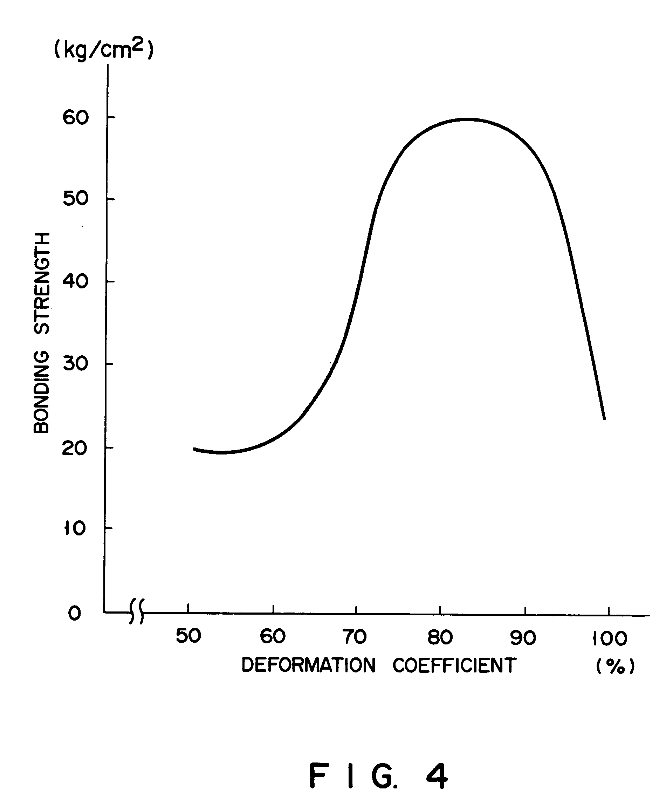

In this respect, a change in the bonding strength with the deformation coefficient of the low-melting point adhesive alloy was measured. A glass substrate with I.T.O. was prepared as a to-be-bonded object, and after a 50 µm thick low-melting point adhesive alloy was bonded to the substrate through thermocompression, the bonding strength was measured. The result is as illustrated in Fig. 4 which shows that a sufficient bonding strength (above 0.392 MPa (40 kg/cm²)) was attained with a 70% to 95% deformation coefficient ((thickness after deformation)/(thickness before deformation)).

Fig. 3B illustrates that plastic-deformable connection terminal 23 and electrode terminal 201 of the semiconductor device are completely bonded together through active alloy 203 that is prepared in the afore-mentioned method.

According to the example above, bumps are formed on the electrode terminals of the semiconductor device; however, this invention is not limited to this example and the bumps can be formed on the connection terminals on the circuit board.

### Example 2

In Fig. 5A, reference numeral "501" denotes a printed circuit board of a polyimide film on which a Sn-plated Cu wiring layer 502 is formed and which is to be subjected to bonding. Wiring layer 502 is patterned in a desired shape in advance by photo engraving process. A low-melting point adhesive alloy layer 503 is locally formed on the surface of wiring layer 502 by thermocompression, which is carried out in such a manner that with pressure 0.98 MPa to 9.81 MPa (10 to 100 kg/cm²) applied, bonding metal layer 503 is deformed under a temperature of 140 to 150°C.

The thickness of the low-melting point adhesive alloy layer 503 was set to be 50 µm.

To the low-melting point adhesive alloy was added In which was confirmed to be very effective in reducing the melting point through the experiments conducted by the present inventors. The low-melting point adhesive alloy comprises Sb of 2 weight %, Pb of 22 weight %, Sn of 66 weight % and In of 10 weight %, and has a softening point of 134°C and a melting point of 160°C.

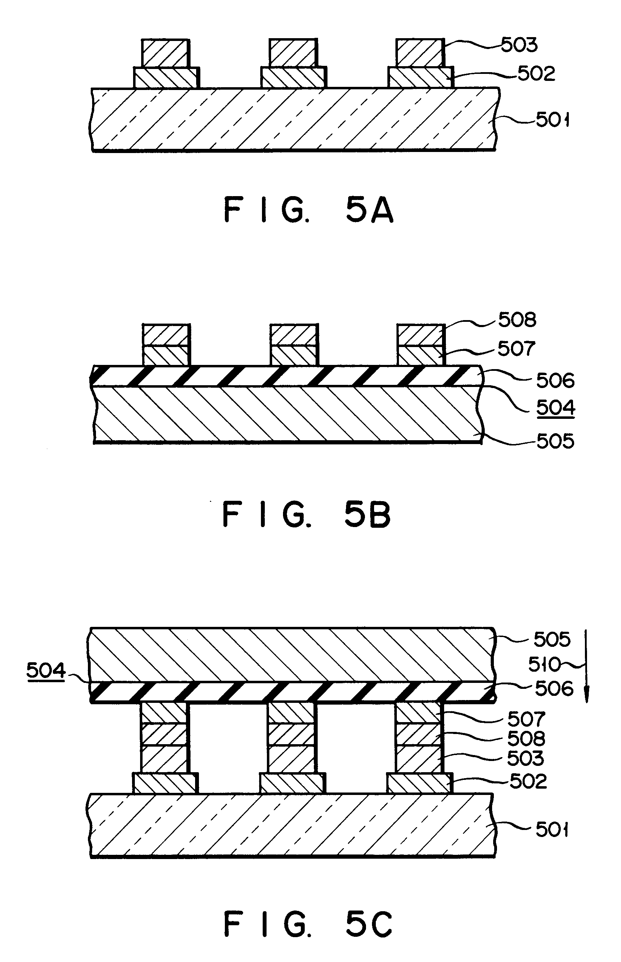

In Fig. 5B, reference numeral "504" denotes a semi-conductor device in which electrodes terminals 507 made of Aℓ, Aℓ-Si, Au or the like, are formed on a semiconductor substrate 505 through an insulative layer 506. A Zn-based thin film 508 was formed on the surface of electrode terminals 507 by sputtering, and it had a thickness of 200 nm (2000 Å).

Zn thin film 508 was applied as an element having a strong affinity with oxygen between electrode terminals 507 of semiconductor device 504 (to-be-bonded object) and low-melting point adhesive alloy layer 503. Alternatively, a film of an element improving the bonding properties such as Sb can be applied.

As shown in Fig. 5C, wiring layer 502 formed on circuit board 501 is bonded to electrode terminals 507 formed on semiconductor device 504 through adhesive alloy layer 503 and Zn thin film 508 by thermal pressure bonding arrow direction 510. This thermocompression is effected in the same manner as is done in Example 1. This causes a plastic deformation to adhesive alloy layer 503 so as to completely bond wiring layer 502 to electrode terminals 507.

### Example 3

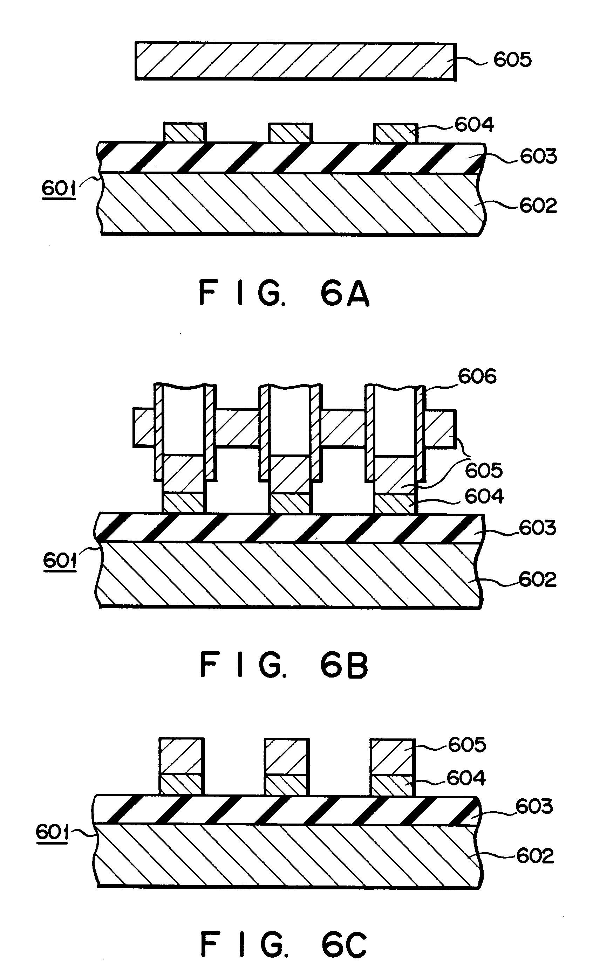

In Fig. 6A, reference numeral "601" denotes a semiconductor device in which electrode terminals 604 made, for example, of Aℓ-Si, are formed through an oxidation film 603 on a semiconductor substrate 602. A low-melting point adhesive alloy foil 605 is disposed above electrode terminals 604 on semiconductor device 601.

Then, as shown in Fig. 6B, after tubular sections 606 of a stamping jig are aligned with the respective electrode terminals 604, pressure is applied to stamping jig to stamp out adhesive alloy foil 605 into predetermined shapes. Tubular sections 606 are made of a material that is easy to process and is hard; for example, each section is made of cupronickel with its distal end formed of beryllium copper. The shape of the distal end is processed to have the desired stamping shape. In addition, a spring needle (not shown) made of tungsten, etc. is disposed inside each tubular section 606 and is designed to be inserted into the distal end of the tubular section so that it pushes the stamped-out adhesive alloy foil 605 out of the tubular section to fixedly transfer on the associated electrode. The pressure applied at the time of the fixing is preferably 0.98 MPa to 9.81 MPa (10 to 100 kg/cm²), and bumps 605 made of the transferred adhesive alloy are deformed by heating semiconductor device 601 on the heat block (not shown) up to 140 to 150°C, for example, thus completing the thermocompression.

In the above manner, bumps 605 made of a low-melting point adhesive alloy are formed on the respective electrode terminals 604 as shown in Fig. 6 C, which represents completed semiconductor device 601.

### Example 4

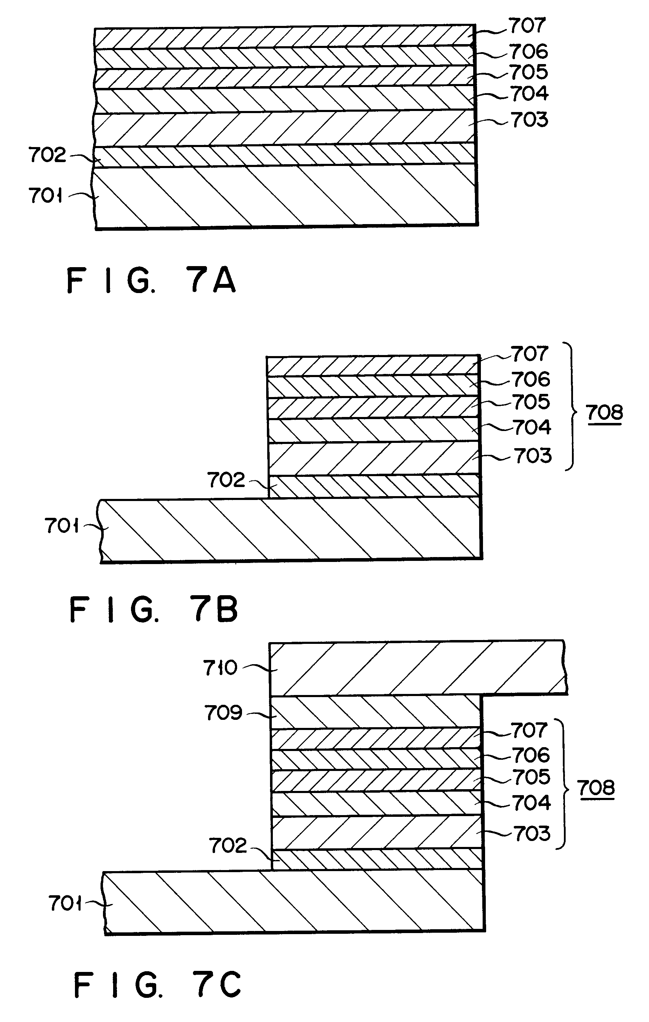

In Fig. 7A, reference numeral "701" denotes a wiring layer which is formed on a printed circuit board made of a polyimide film (not shown) and is plated with a tin film 702 having a thickness of 200 nm (2000 Å). This wiring layer is patterned into a desired shape. A 29 µm-thick Pb thin film 703 is formed on tin film 702 by sputtering, and on this film 703 are sequentially formed a 12 µm-thick Sn thin film 704, a 7 µm-thick Zn thin film 705, 1 µm-thick In thin film 706 and 1 µm-thick Sb thin film 707 also by sputtering.

Then, as shown in Fig. 7B, these films are selectively etched to remove the unnecessary portions and are then subjected to pattering to form a lamination pattern 708.

As shown in Fig. 7C, Aℓ-Si electrode 709 formed on the surface of semiconductor device 710 and lamination pattern 708 were abutted against each other and heated up to 140 to 150°C while applied with a pressure of 0.98 MPa to 9.81 MPa (10 to 100 kg/cm²), thereby alloying lamination pattern 708 to form a low-melting point adhesive alloy. This thermocompression, at the same time, deforms the low-melting point adhesive alloy, which completed the bonding process. In this manner, highly reliable bonding was easily effected.

## Claims

1. A method of electrically connecting an electronic component to an object, comprising
a first step of adhering a low-melting point bonding metal alloy, which includes In, Sb and at least two elements selected from the group consisting of Pb, Sn, Zn, Cd and Bi, to an electrode terminal (201,507,604,709) of said electronic component (11,504,601,710), and to a connection terminal (23,502,701) of said object (24,501); and
a second step of thermo-compressing said low-melting point bonding metal alloy (203) to said electrode terminal (201) and to said connection terminal (23), at a temperature between a softening point of said bonding metal alloy (203) and a melting point of said bonding metal alloy (203) and under a pressure of 0.98 MPa to 9.81 MPa (10 to 100 kg/cm²).

2. The method according to claim 1, characterized in that said low-melting point bonding metal alloy contains a further additive having a strong affinity with oxygen.

3. The method according to claim 2, characterized in that said additive having a strong affinity with oxygen comprises at least one element selected from a group of Zn, Al, Ti, Si, Cr, and Be or a rare earth element.

4. The method according to claim 1, characterized in that said first and second steps are carried out with a connection terminal (201) being made of a transparent material.

5. The method according to claim 4, characterized in that said transparent material is selected from a group of SnO₂, In₂O₃, ATO (Sb doped SnO₂, Antimony-Tin-Oxide) and ITO (Sn doped In₂O₃, Indium-Tin-Oxide).

6. The method according to claim 1, characterized in that said electronic component (11) is a semiconductor integrated circuit device.

7. The method according to claim 6, characterized in that said first and second steps are carried out with said electrode terminal of said electronic component being made of Al.

8. The method according to claim 6, characterized in that first and second steps are carried out with said electrode terminal of said electronic component being formed by lamination of Al and Sn.

9. The method according to claim 6, characterized in that first and second steps are carried out with said electrode terminal of said electronic component being formed by lamination of Al, Au and Sn.

10. The method according to claim 1, characterized in that a thin film (508) of an element for improving a bonding property at the bonding surface between said low melting bonding metal alloy (503) and said electronic component (504) is applied between said low-melting point bonding metal alloy (503) and the electrode terminal (507) of said electronic component (504).

11. The method according to claim 1, characterized in that a thin film (508) of an element having a strong affinity with oxygen is applied between said low-melting point bonding metal alloy (503) and the electrode terminal (507) of said electronic component (504).

12. The method according to claim 1, characterized in that in said first step, after a low-melting point bonding metal alloy (605) is disposed above said electrode terminal (604), that portion of said low-melting point bonding alloy (605) which is aligned with said electrode terminal (604) is stamped out and is fixedly transferred onto said electrode terminal (604).

13. The method according to claim 1, characterized in that in said first step, after a plurality of elements (703 - 707) constituting a low-melting point bonding metal alloy are sequentially laminated, at least a surface layer portion (707) of said laminated elements is alloyed to form a low-melting point bonding metal alloy layer.

14. The method according to claim 1, characterized in that said connection terminal (23,502) is formed on a film (24,501) made of organic material.

15. The method according to claim 1, characterized in that said electrode terminal (201) is formed on an insulative substrate (202) made of inorganic material.

16. The method according to claim 1, characterized in that said connection terminal (23,502) is formed by Cu plated with Sn.

## Patentansprüche

1. Verfahren zum elektrischen Verbinden eines elektronischen Bauelements mit einem zweiten Objekt, umfassend:
einen ersten Schritt eines Anhaftenlassens einer niedrigschmelzenden Bondingmetallegierung mit In, Sb und mindestens zwei Elementen, ausgewählt aus der Gruppe aus Pb, Sn, Zn, Cd und Bi, an einem Elektrodenanschluß (201, 507, 604, 709) des elektronischen Bauelements (11, 504, 601, 710) und einem Verbindungsanschluß (23, 502, 701) des zweiten Objekts (24, 501) und
einen zweiten Schritt eines Wärmedruckverpressens der niedrigschmelzenden Bondingmetallegierung (203) mit dem Elektrodenanschluß (201) und dem Verbindungsanschluß (23) bei einer Temperatur zwischen einem Erweichungspunkt der Bondingmetallegierung (203) und einem Schmelzpunkt der Bondingmetallegierung (203) und unter einem Druck von 0,98 MPa bis 9,81 MPa (10 - 100 kg/cm²).

2. Verfahren nach Anspruch 1, dadurch gekennzeichnet, daß die niedrigschmelzende Bondingmetallegierung einen weiteren Zusatzstoff mit einer starken Affinität für Sauerstoff enthält.

3. Verfahren nach Anspruch 2, dadurch gekennzeichnet, daß der Zusatzstoff mit starker Affinität für Sauerstoff aus mindestens einem Element, ausgewählt aus der Gruppe Zn, Al, Ti, Si, Cr und Be, oder einem Seltenerdeelement besteht.

4. Verfahren nach Anspruch 1, dadurch gekennzeichnet, daß die ersten und zweiten Schritte mit einem aus einem transparenten Werkstoff hergestellten Elektrodenanschluß (201) durchgeführt werden.

5. Verfahren nach Anspruch 4, dadurch gekennzeichnet, daß der transparente Werkstoff aus einer Gruppe aus SnO₂, In₂O₃, ATO (Sb-dotiertes SnO₂, Antimon-Zinn-Oxid) und ITO (Sn-dotiertes In₂O₃, Indium-Zinn-Oxid) ausgewählt wird.

6. Verfahren nach Anspruch 1, dadurch gekennzeichnet, daß das elektronische Bauelement (11) eine integrierte Halbleiterschaltungsanordnung ist.

7. Verfahren nach Anspruch 6, dadurch gekennzeichnet, daß die ersten und zweiten Schritte mit dem aus Al hergestellten Elektrodenanschluß des elektronischen Bauelements durchgeführt werden.

8. Verfahren nach Anspruch 6, dadurch gekennzeichnet, daß die ersten und zweiten Schritte mit dem durch Laminieren oder Schichten von Al und Sn geformten Elektrodenanschluß des elektronischen Bauelements durchgeführt werden.

9. Verfahren nach Anspruch 6, dadurch gekennzeichnet, daß die ersten und zweiten Schritte mit dem durch Laminieren oder Schichten von Al, Au und Sn geformten Elektrodenanschluß des elektronischen Bauelements durchgeführt werden.

10. Verfahren nach Anspruch 1, dadurch gekennzeichnet, daß ein dünner Film (508) eines Elements zur Verbesserung der Verbindungs- bzw. Bondingeigenschaft an der Verbindungs bzw. Bondingfläche zwischen der niedrigschmelzenden Bondingmetallegierung (503) und dem elektronischen Bauelement (504) zwischen der niedrigschmelzenden Bondingmetallegierung (503) und dem Elektrodenanschluß (507) des Bauelements (504) aufgebracht wird.

11. Verfahren nach Anspruch 1, dadurch gekennzeichnet, daß ein dünner Film (508) eines Elements einer starken Affinität für Sauerstoff zwischen der niedrigschmelzenden Bondingmetallegierung (503) und dem Elektrodenanschluß (507) des elektronischen Bauteils (504) aufgebracht wird.

12. Verfahren nach Anspruch 1, dadurch gekennzeichnet, daß im ersten Schritt nach dem Anordnen einer niedrigschmelzenden Bondingmetallegierung (605) über dem Elektrodenanschluß (604) der Bereich der niedrigschmelzenden Bondingmetallegierung (605), der mit dem Elektrodenanschluß (604) ausgefluchtet ist, ausgestanzt und fest(gelegt) auf den Elektrodenanschluß (604) übertragen wird.

13. Verfahren nach Anspruch 1, dadurch gekennzeichnet, daß im ersten Schritt nach dem aufeinanderfolgenden Laminieren oder Schichten einer Anzahl Elemente (703-707), die eine niedrigschmelzende Bondingmetallegierung bilden, mindestens ein Oberflächenschichtbereich (707) der laminierten Elemente zur Bildung einer niedrigschmelzenden Bondingmetallegierungsschicht legiert wird.

14. Verfahren nach Anspruch 1, dadurch gekennzeichnet, daß der Verbindungsanschluß (23, 502) auf einem Film (24, 501) aus organischem Material geformt wird.

15. Verfahren nach Anspruch 1, dadurch gekennzeichnet, daß der Elektrodenanschluß (201) auf einem isolierenden Substrat (202) aus anorganischem Material geformt wird.

16. Verfahren nach Anspruch 1, dadurch gekennzeichnet, daß der Verbindungsanschluß (23, 502) aus mit Sn plattiertem Cu geformt wird.

## Revendications

1. Procédé pour relier électriquement un composant électronique et un objet, comprenant une première étape d'adhésion d'un alliage métallique de liaison à faible point de fusion, qui comprend In, Sb et au moins deux éléments choisis dans le groupe formé par Pb, Sn, Zn, Cd et Bi, à une borne d'électrode (201, 507, 604, 709) dudit composant électronique (11, 504, 601, 710) et à une borne de jonction (23, 502, 701) dudit objet (24, 501), et une seconde étape de thermocompression dudit alliage métallique de liaison à faible point de fusion (203) sur ladite borne d'électrode (201) et sur ladite borne de jonction (23), à une température située entre le point de ramollissement dudit alliage métallique de liaison (203) et le point de fusion dudit alliage métallique de liaison (203) et sous une pression de 0,98 MPa à 9,81 MPa (10 à 100 kg/cm²).

2. Procédé selon la revendication 1, caractérisé en ce que ledit alliage métallique de liaison à faible point de fusion contient un autre additif ayant une forte affinité pour l'oxygène.

3. Procédé selon la revendication 2, caractérisé en ce que ledit additif ayant une forte affinité pour l'oxygène comprend au moins un élément choisi dans le groupe formé par Zn, Al, Ti, Si, Cr et Be ou un élément des terres rares.

4. Procédé selon la revendication 1, caractérisé en ce que lesdites première et seconde étapes sont accomplies avec une borne de jonction (201) constituée par un matériau transparent.

5. Procédé selon la revendication 4, caractérisé en ce que ledit matériau transparent est choisi dans le groupe formé par SnO₂, In₂O₃, ATO (SnO₂ dopé par Sb, oxyde d'antimoine et d'étain) et ITO (In₂O₃ dopé par Sn, oxyde d'indium et d'étain).

6. Procédé selon la revendication 1, caractérisé en ce que ledit composant électronique (11) est un composant à circuit intégré à semiconducteur.

7. Procédé selon la revendication 6, caractérisé en ce que lesdites première et seconde étapes sont accomplies tandis que ladite borne d'électrode dudit composant électronique est constituée par Al.

8. Procédé selon la revendication 6, caractérisé en ce que lesdites première et seconde étapes sont accomplies tandis que ladite borne d'électrode dudit composant électronique est formée par stratification de Al et Sn.

9. Procédé selon la revendication 6, caractérisé en ce que lesdites première et seconde étapes sont accomplies tandis que ladite borne d'électrode dudit composant électronique est formée par stratification de Al, Au et Sn.

10. Procédé selon la revendication 1, caractérisé en ce qu un film mince (508) d'un élément destiné à améliorer les propriétés de liaison au niveau de la surface de liaison entre ledit alliage métallique de liaison à faible point de fusion (503) et ledit composant électronique (504) est appliqué entre ledit alliage métallique de liaison à faible point de fusion (503) et la borne d'électrode (507) dudit composant électronique (504).

11. Procédé selon la revendication 1, caractérisé en ce qu'un film mince (508) d'un élément ayant une forte affinité peur l'oxygène est appliqué entre ledit alliage métallique de liaison à faible point de fusion (503) et la borne d'électrode (507) dudit composant électronique (504).

12. Procédé selon la revendication 1, caractérisé en ce que, dans ladite première étape, un alliage métallique de liaison à faible point de fusion (605) ayant été disposé au-dessus de ladite borne d'électrode (604), la partie dudit alliage métallique de liaison à faible point de fusion (605) qui est alignée avec ladite borne d'électrode (604) est découpée à la matrice et est transférée de manière fixe sur ladite borne d'électrode (604).

13. Procédé selon la revendication 1, caractérisé en ce que, dans ladite première étape, une multiplicité d'éléments (703-707) constituant un alliage métallique de liaison à faible point de fusion ayant été stratifiés successivement, au moins une partie formant couche superficielle (707) desdits éléments stratifiés est alliée pour former une couche d'alliage métallique de liaison à faible point de fusion.

14. Procédé selon la revendication 1, caractérisé en ce que ladite borne de jonction (23, 502) est formée sur un film (24, 501) constitué par un matériau organique.

15. Procédé selon la revendication 1, caractérisé en ce que ladite borne d'électrode (201) est formée sur un substrat isolant (202) constitué par un matériau inorganique.

16. Procédé selon la revendication 1, caractérisé en ce que ladite borne de jonction (23, 502) est constituée par Cu revêtu de Sn.
